# EUROPEAN PATENT SPECIFICATION

(11) **EP 3 846 604 B1**
(45) Date of publication and mention of the grant of the patent: **10.12.2025**
(21) Application number: 18932020.3
(22) Date of filing: 28.08.2018
(51) Int. Cl.: H05K 13/00, H05K 13/08

(54) **CONTROL PROGRAM CHECKING DEVICE**
ÜBERPRÜFUNGSVORRICHTUNG FÜR STEUERPROGRAMM
DISPOSITIF DE VÉRIFICATION DE PROGRAMME DE COMMANDE

(43) Date of publication of application: 07.07.2021
(73) Proprietor: Fuji Corporation, Chiryu-shi, Aichi 472-8686 (JP)
(72) Inventor: SHIMIZU Koji, Chiryu-shi, Aichi 472-8686 (JP)
(74) Representative: Grünecker Patent- und Rechtsanwälte PartG mbB
(86) International application number: PCT/JP2018/031729
(87) International publication number: WO 2020/044431

(56) References cited:
- EP-B1- 2 575 419
- WO-A1-2018/092250
- JP-A- 2002 171 099
- JP-A- 2008 083 758
- JP-A- 2009 081 456
- JP-A- 2014 150 176
- JP-A- 2017 146 859
- JP-B2- 5 781 835
- US-A1- 2006 064 192

## Description

### Technical Field

The present invention relates to a control program check device.

### Background Art

A board work machine executes a production process that produces a board product. JP-A-2017-199740 discloses a component mounter as a board work machine. Component mounter of JP-A-2017-199740 executes a mounting process for mounting a component held by a mounting head on a board based on a control program. The control program determines propriety of execution of a production process by, for example, a dedicated check device. Specifically, the check device determines whether a movement instruction exceeding a movable
range or an upper limit of the mounting head of the component mounter is included in the control program.
JP 5 781835 relates to an apparatus and a method for supporting the production of an electric circuit by an electric circuit production line. A working condition change in a substrate operation is recognized according to working machine-related information including information related to at least one of an operation executed by a substrate operating machine and a procedure applied to the substrate operating machine in the substrate operation.
EP 2 575 419 B1 relates to a substrate transfer apparatus and a substrate transfer method to transfer a substrate stopped at a first position toward a second position and to stop the substrate at the second position, and a surface mounter that mounts components on the substrate positioned at the second position by the substrate transfer apparatus. US 2006/0064192 A1 relates to a substrate-related-operation performing system that improves its operation efficiency by preventing an error in replacing, for a substrate-related-operation performing apparatus thereof, an operation performing program with another operation performing program. An operation-object code corresponding to a mounting program selected for a component mounting apparatus as a judgment-object operation performing apparatus is compared with a substrate code corresponding to the most downstream circuit substrate of the circuit substrates present on an upstream side of the judgment-object operation performing apparatus, whereby whether the mounting program is appropriate is judged.

### Summary

### Technical Problem

However, even if various operation instructions included in the control program is within a range of an operation capability of the board work machine, quality required by a board product to be produced may differ and there is a possibility that an operation instruction, which is not appropriate, is included in the control program for some board products.

An object of the present specification is to provide a control program check device capable of improving quality of a board product to be produced, by more reliably determining good or bad quality of a control program used in a production process of a board work machine.

This object is solved by the subject matter of independent claim 1.

Embodiments are defined by the dependent claims.

### Solution to Problem

The present specification discloses a control program check device that performs a check process of a control program used for a production process by a board work machine, the check device including: a reference data storage section storing reference data in which a determination reference for an execution propriety of the production process using the control program is set by a manufacturer of the board work machine for each of multiple determination items; a condition data storage section configured to store condition data in which a determination condition that is set to a level higher than the determination reference for at least a part of the multiple determination items is set by a user of the board work machine for each of the determination items; and a determination section configured to determine good or bad quality of the control program based on the reference data and the condition data in the check process.

### Advantageous Effect of the Invention

With such a configuration, since the condition data can be made to correspond to a specific board work machine or a specific production process, it is possible to more reliably determine the good or bad quality of the control program. As a result, it is possible to improve the quality of the board product to be produced.

### Brief Description of Drawings

Fig. 1 is a schematic view illustrating a production system including a check device in an embodiment.
Fig. 2 is a schematic view illustrating a configuration of a component mounter in the production line of Fig. 1.
Fig. 3 is a diagram illustrating a control program and part data.
Fig. 4 is a flowchart illustrating a mounting process by the component mounter.
Fig. 5 is a diagram illustrating reference data and condition data.
Fig. 6 is a flowchart illustrating a check process of the control program.

### Description of Embodiments

### 1. Overview of Production System 1

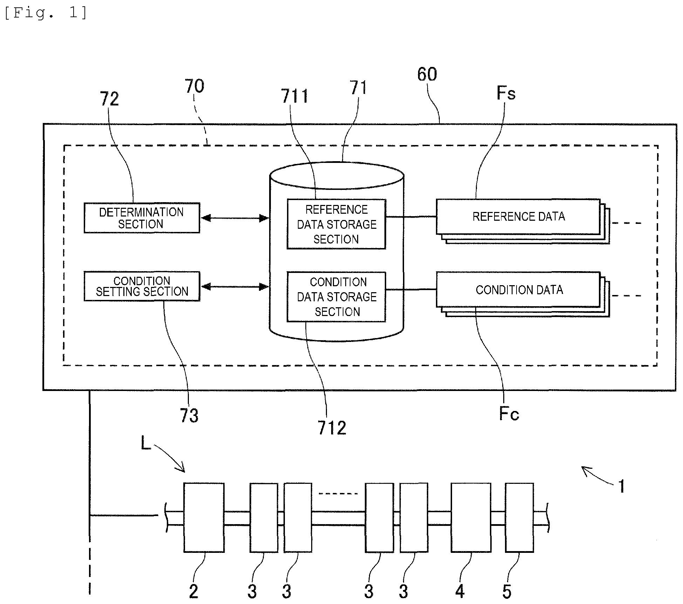

A control program check device is applied to, for example, host computer 60 constituting production system 1 of a board product. The check device allows the control program to be a target of the check. In the present embodiment, an aspect is illustrated in which the control program used in a mounting process by component mounter 3 as a board work machine is the target of the check. As illustrated in Fig. 1, production system 1 is configured by one or more production lines L and host computer 60 that collectively manages production lines L.

### 2. Configuration of Production Line L

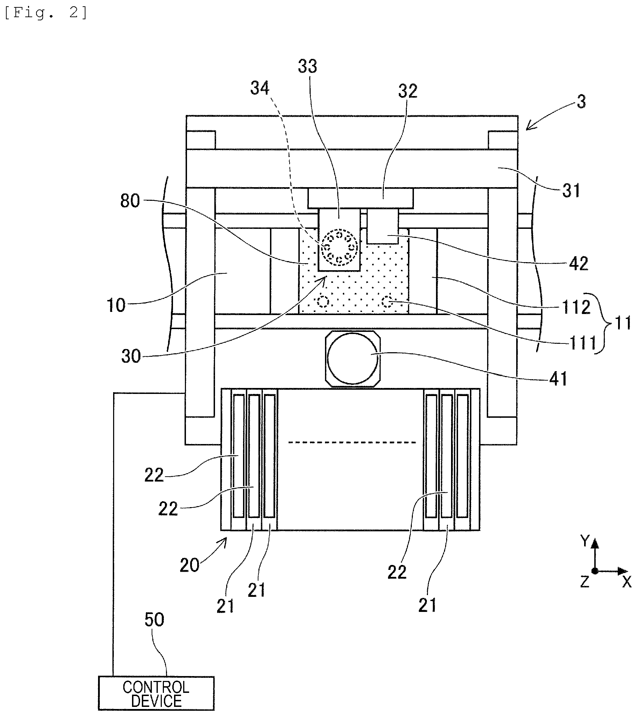

Production line L is configured by installing multiple board work machines in a conveyance direction of board 80 (see Fig.2). Each of multiple board work machines is communicably connected to host computer 60. As illustrated in Fig. 1, production line L includes printer 2, multiple component mounters 3, reflow furnace 4, and inspector 5 as multiple board work machines.

Printer 2 prints a paste-like solder to a mounting position of the component in conveyed-in board 80. Each of multiple component mounter 3 mounts the component on board 80 conveyed from an upstream side of production line L. A configuration of component mounter 3 will be described later. Reflow furnace 4 heats board 80 conveyed from the upstream side of production line L, and performs soldering by melting the solder on board 80. Inspector 5 inspects whether an appearance or a function of the board product produced by production line L is normal.

A configuration of production line L may be appropriately added or changed in accordance with, for example, the type of the board product to be produced. Specifically, in production line L, a board work machine such as a buffer device for temporarily holding board 80 to be conveyed, a board supplying device, a board flipping device, various inspection devices, a shield mounting device, an adhesive application device, a chip transfer device, or an ultraviolet ray irradiation device can be appropriately installed.

### 3. Configuration of Component Mounter 3

Component mounter 3 executes a mounting process of mounting the component on board 80. As illustrated in Fig. 2, component mounter 3 includes board conveyance device 10, component supply device 20, component transfer device 30, part camera 41, board camera 42, and control device 50. In the following description, it is assumed that a first direction of a horizontal direction and a left-right direction of component mounter 3 is X-direction, a second direction of the horizontal direction intersecting X-direction and a front-rear direction of component mounter 3 is Y-direction, and a vertical direction (front-rear direction in Fig. 2) orthogonal to X-direction and Y-direction is Z-direction.

Board conveyance device 10 subsequently conveys board 80 in the conveyance direction along guide rails and positions board 80 at a predetermined position in the machine. Board conveyance device 10 conveys out board 80 to the outside of the machine of component mounter 3 after the mounting process of the components by component mounter 3 is completed. Further, board conveyance device 10 has backup device 11 for clamping positioned board 80 between the guide rails.

Backup device 11 supports board 80 by bringing backup member 111 to come into contact with a lower surface of board 80. Therefore, backup device 11 clamps board 80 between a pair of guide rails and maintains a height of a portion coming into contact with backup member 111, thereby preventing board 80 from bending. Backup member 111 is disposed on backup plate 112 disposed to face a lower surface of positioned board 80. Backup device 11 switches between a clamped state and an unclamped state of board 80 by lifting and lowering backup plate 112.

Component supply device 20 supplies the component to be mounted on board 80. Component supply device 20 includes multiple slots 21 disposed side by side in X-direction, and feeders 22 respectively set in multiple slots 21. Feeder 22 feeds and moves a carrier tape in which multiple components are stored. Thus, feeder 22 supplies the component to be picked up at a supply position provided on a distal end side of feeder 22.

Component transfer device 30 transfers the component supplied by component supply device 20 to a predetermined mounting position (work position) on board 80 conveyed in the machine by board conveyance device 10. Head driving device 31 of component transfer device 30 moves moving table 32 in the horizontal direction (X-direction and Y-direction) by a linear motion mechanism. Mounting head 33 is exchangeably fixed to moving table 32 by a clamp member (not illustrated). Mounting head 33 supports multiple suction nozzles 34 rotatably and liftably. Suction nozzle 34 picks up the component which is supplied by feeder 22 by the supplied negative pressure air. As described above, suction nozzle 34 is a holding member that holds the component by being supplied by the negative pressure air. In addition to suction nozzle 34, a chuck or the like for gripping and holding the component may be adopted as the holding member.

Part camera 41 and board camera 42 are digital imaging devices each having an imaging element such as a CMOS. Part camera 41 and board camera 42 perform imaging based on a control signal, and sends out the image data acquired by the imaging. Part camera 41 is fixed to a base such that an optical axis is upward in Z-direction. Part camera 41 is configured to be capable of imaging the component held by suction nozzle 34 of mounting head 33 from below. Board camera 42 is fixed to moving table 32 such that the optical axis is downward in Z-direction and moves integrally with mounting head 33 with the movement of moving table 32. Board camera 42 is configured to be capable of imaging board 80 from above.

Control device 50 is mainly configured by a CPU, various memories, and a control circuit. Control device 50 executes the mounting process of mounting the component on board 80. The mounting process described above includes a process repeating, over multiple times, a pick-and-place cycle (hereinafter, also referred to as a "PP cycle") for picking up the component supplied by component supply device 20 and mounting the component on the mounting position in board 80.

In the mounting process, control device 50 controls an operation of component transfer device 30 based on a control program for designating the mounting position on board 80, part data in which various types of information are set for each component type, or the like, as a result of information and image processing output from various sensors. Thus, positions and angles of multiple suction nozzles 34 supported by mounting head 33 are controlled. Details of the mounting process by component mounter 3 will be described later.

### 4. Control Program M1 and Part Data M2

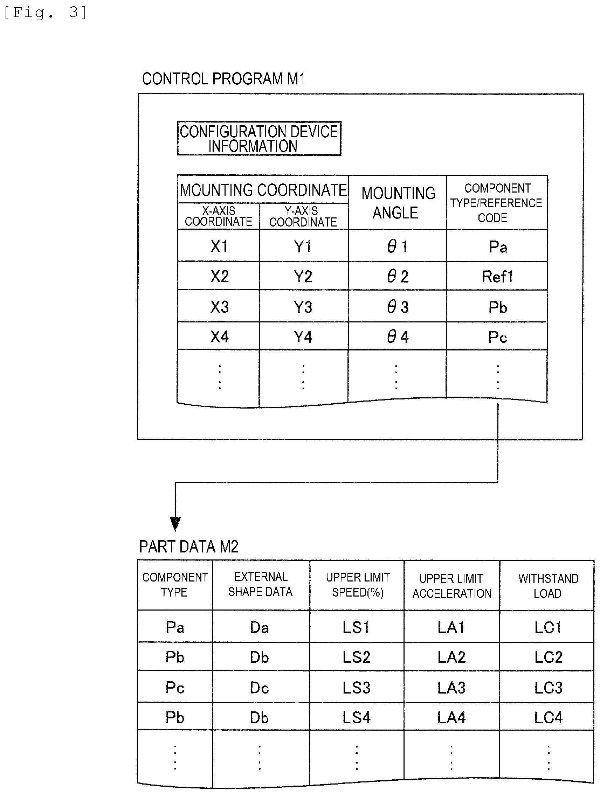

Control program M1 and part data M2 used in the mounting process by component mounter 3 will be described with reference to Fig. 3. Control program M1 is generated based on design information of the board product. As illustrated in Fig. 3, in control program M1, the mounting position and a mounting angle of various components with respect to board 80 are set for each component type.

In control program M1, a reference code can be set in place of the component type described above. The reference code is a code for instructing a reference to the component type. Control program M1 including the reference code specifies the component type by using correspondence data (bills of materials (BOM) data) that associates the reference code with the component type in the mounting process. In such a configuration, different types of components can be mounted at the same mounting position by changing the correspondence data. For example, in a case where multiple types of board products having some different specifications are produced, the control program M1 described above is applied.

In addition, control program M1 includes configuration device information of component mounter 3. The "configuration device" described above includes, for example, board conveyance device 10, component supply device 20, and component transfer device 30. Furthermore, feeder 22 constituting component supply device 20, and mounting head 33 constituting component transfer device 30 may be individual configuration devices. The configuration devices described above are removably configured with respect to component mounter 3, and the type and quantity in accordance with the board product to be produced, and a combination thereof may be changed.

Further, in the configuration device, in a case where the firmware that performs a predetermined function is incorporated in advance, a version of the firmware is set in accordance with a functions required for the mounting process to be executed. In the configuration as described above, control device 50 recognizes the configuration device by communication between various configuration devices, for example, at a time of power-on of component mounter 3. Then, for the configuration device information of control program M1, in a case where it is necessary to designate the type and combination of the configuration devices and the firmware version in the mounting process scheduled to be executed, at least one of these is designated.

Part data M2 sets an external shape, a withstand load, a maximum speed of movement, and a maximum acceleration of movement of the component for each component type. The external shape of the component is used, for example, in a state recognition process using part camera 41, and corresponds to a template to be collated with the components included in the image data, and information indicating dimensions and feature sections of the component. The withstand load of the component is an allowable value of a load that the component receives from the holding member such as suction nozzle 34.

The maximum speed of the movement is an allowable value of the speed of the component to be moved by component transfer device 30. In part data M2, the maximum speed of the movement may be set at a ratio to the maximum speed on a function of component transfer device 30. Thus, for example, the component type of which the maximum speed of the movement is set to 80% in part data M2 is moved so as not to exceed 80% of the maximum speed of component transfer device 30 in the mounting process. The maximum acceleration of the movement is an allowable value of the acceleration (including deceleration) of the component to be moved by component transfer device 30.

### 5. Mounting Process by Component Mounter 3

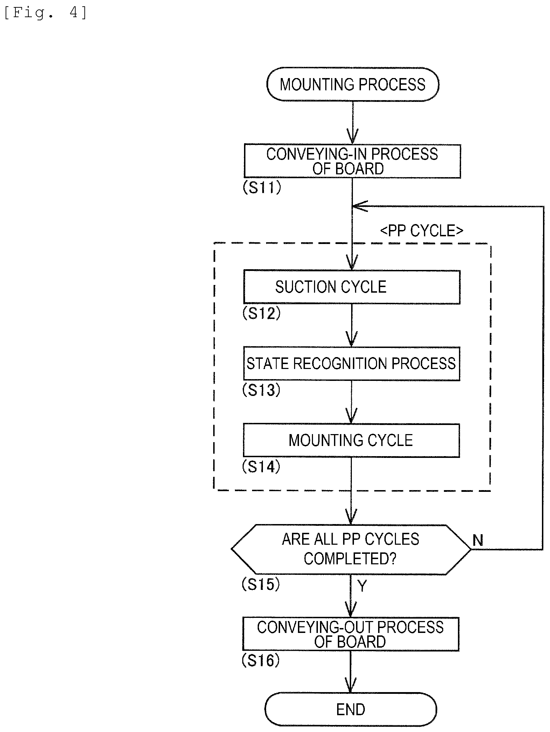

The mounting process by component mounter 3 will be described with reference to Fig. 4. When the mounting process is executed, various configuration devices of component mounter 3 are set up. Specifically, in backup device 11 of board conveyance device 10, multiple backup members 111 are disposed at predetermined positions of backup plate 112. Feeders 22 for loading carrier tapes are set in multiple slots 21 of component supply device 20.

In addition, firmware incorporated in various configuration devices is upgraded or downgraded as necessary. Control device 50 acquires a setup state (including the firmware version) by communication with various configuration devices. Then, control device 50 collates the configuration device information included in control program M1 with the actual state of the configuration device, and executes the mounting process based on control program M1 in a case where the setup is normally performed.

In the mounting process, as illustrated in Fig. 4, control device 50 first executes a conveying-in process of board 80 (S11). In the conveying-in process of board 80, board conveyance device 10 positions board 80 at a predetermined position in the machine while conveying board 80 in the machine of component mounter 3. Further, board conveyance device 10 clamps positioned board 80 by backup device 11. At this time, a tip of backup member 111 is in the contact state with the lower surface of board 80.

Next, control device 50 executes a suction cycle in which the components are subsequently picked up by multiple suction nozzles 34 (S12). More particularly, control device 50 moves mounting head 33 above feeder 22 that supplies a predetermined type of component in component supply device 20. Then, control device 50 lowers suction nozzle 34 to pick up the component, and then lifts suction nozzle 34 again. In the suction cycle, the movement of mounting head 33 and the lowering and lifting of suction nozzle 34 as described above are repeated, and multiple components are respectively held by suction nozzles 34.

Subsequently, control device 50 executes a state recognition process for recognizing the holding state of the components held respectively in multiple suction nozzles 34 (S13). More particularly, control device 50 moves mounting head 33 above part camera 41 and sends out an imaging command to part camera 41. Control device 50 performs the image processing of the image data acquired by imaging of part camera 41 and recognizes a posture (position and angle) of the component held in each of multiple suction nozzles 34. At this time, the template indicating the external shape of the component in part data M2 corresponding to the component is used for the image processing.

Thereafter, control device 50 executes a mounting cycle in which the components are subsequently mounted on board 80 by multiple suction nozzles 34 (S14). More particularly, control device 50 moves mounting head 33 above a predetermined mounting position on board 80. At this time, control device 50 corrects the position and the angle of suction nozzle 34 based on a result of the state recognition process (S13). Then, control device 50 lowers suction nozzle 34 to mount the component, and then lifts suction nozzle 34 again. In the mounting cycle, the movement of mounting head 33, and the lowering and lifting of suction nozzle 34 as described above are repeated to respectively mount multiple components on board 80.

In a case where the mounting of all the components to be mounted on present board 80 is not completed (S15: No), control device 50 repeatedly executes the PP cycle (S12 to S14) until the mounting is completed. In a case where the mounting of all the components is completed (S15: Yes), control device 50 executes a conveying-out process of board 80 (S16). In the conveying-out process of board 80, board conveyance device 10 conveys out board 80 to the outside of the machine of component mounter 3 while unclamping board 80 which is positioned.

In the PP cycle (S12-S14) described above, when the multiple suction nozzles 34 are moved and rotated with the movement of mounting head 33 or the like, control device 50 controls the movement (including rotation) of the component so as not to exceed the maximum speed and the maximum acceleration set in part data M2 corresponding to the components held by the multiple suction nozzles 34. In a case where multiple types of components are held in mounting head 33, control device 50 adjusts the movement speed of mounting head 33, the rotation speed of suction nozzle 34, and the lifting and lowering speed, with reference to those in which the maximum speed and the maximum acceleration of the component are the minimum.

### 6. Configuration of Check Device 70

In the present embodiment, host computer 60 functions as the configuration device and check device 70 of control program M1 by the installed software. In the present embodiment, check device 70 determines good or bad quality of control program M1 used in the mounting process by component mounter 3 that is one of the board work machines.

Here, control program M1 described above is generated by the user of component mounter 3 based on design information of the board product or the like. Therefore, in control program M1, it is necessary to check control program M1 before executing the mounting process, for example, whether an instruction for mounting the component at a position exceeding the movable range of mounting head 33 is included. In addition, in control program M1, it is necessary to check control program M1, for example, whether a movement instruction exceeding the upper limit speed or the upper limit acceleration of mounting head 33 is included.

Since the movable range and the upper limit speed on the configuration of the machine as described above change depending on the type of component mounter 3 and the configuration device, the check of control program M1 is generally performed based on reference data Fs set by the manufacturer of component mounter 3. In other words, the check based on reference data Fs as described above determines whether the various operation instructions included in the control program are within the range of the operation capability of component mounter 3 and the mounting process by using control program M1 can be executed.

However, even if control program M1 satisfies multiple determination references set in reference data Fs, the determination reference may be loose (level of determination may be low) from a viewpoint of quality improvement or from a viewpoint of complying with the required specification. Specifically, in the case of the component of which holding by the holding member such as suction nozzle 34 is not easy, the speed or the acceleration during the movement in the XY-directions is desirably set lower than the upper limit of the operation capability of component mounter 3. At this time, in the determination of the good or bad quality of control program M1 by using reference data Fs, the determination reference is loose, and it cannot be determined whether an appropriate movement speed or acceleration is instructed.

However, versatility has to be secured in reference data Fs and it is difficult to set dedicated reference data Fs for each user. Further, the user may adjust the movement speeds of mounting head 33 and suction nozzle 34, or the like based on a required specification and a past production record of the board product. Therefore, it is desired that the user can also adjust the reference when determining the good or bad quality of control program M1.

Therefore, check device 70 of the present embodiment adopts a configuration that enables the determination of the good or bad quality of control program M1 by using condition data Fc set by the user. Therefore, check device 70 improves the quality of the board product which is produced as a result and the like. Specifically, as illustrated in Fig. 1, check device 70 includes storage section 71, determination section 72, and condition setting section 73.

Storage section 71 is configured of an optical drive device such as a hard disk device, a flash memory, or the like. In the present embodiment, storage section 71 has reference data storage section 711 and condition data storage section 712 as storage regions. Reference data storage section 711 stores reference data Fs in which the determination reference for the execution propriety of the production process (mounting process) by using control program M1 is set by the manufacturer of the board work machine (component mounter 3) for each of multiple determination items.

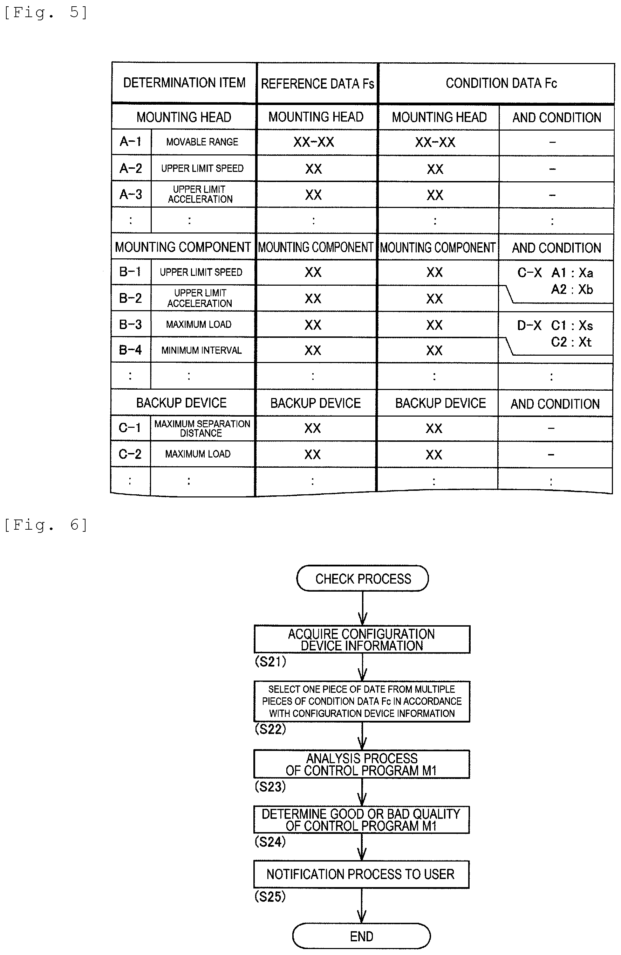

In addition, condition data storage section 712 stores condition data Fc in which the determination condition set to a level higher than the determination reference for at least a part of the multiple determination items is set by the user of the board work machine (component mounter 3) for each of the determination items. As illustrated in Fig. 5, the determination items in reference data Fs and condition data Fc include at least one of the movable range, the upper limit speed, and the upper limit acceleration of mounting head 33.

Further, the determination items in reference data Fs and condition data Fc include the upper limit speed and the upper limit acceleration of the component held in mounting head 33, and the maximum load applied from mounting head 33. Further, the determination items in reference data Fs and condition data Fc include minimum intervals of multiple components mounted on board 80. In the present embodiment, the "interval" of the components corresponds to a length of a line segment connecting outer peripheral edges of adjacent components and is not a distance (distance of respective mounting positions) between centers of the components.

The determination items in reference data Fs and condition data Fc include at least one of the number of backup members 111 used in the mounting process, a maximum separation distance between the mounting position on board 80 and the backup member in the mounting process, and the maximum load applied to board 80 at the mounting position. Further, the determination items in reference data Fs and condition data Fc include the conveyance speed of board 80 in the conveying-in process (S11) of board 80.

The determination items in reference data Fs and condition data Fc include the type of the suction nozzle 34 that holds the component in the mounting process. In reference data Fs, the determination reference for each of multiple determination items is set by the manufacturer corresponding to the type of component mounter 3 to which reference data Fs is applied. In condition data Fc, a determination condition of a level (strict condition equal to or higher than the determination reference) higher than the determination reference is set by the user.

As a method of setting the determination condition to a level higher than the determination reference in condition data Fc, for example, in addition to setting a range narrower than the movable range of mounting head 33 or setting a speed lower than the upper limit speed of the movement, multiple determination items may be correlated. Specifically, it is conceivable to evaluate a value or a range of a specific determination item in a stepwise manner, and to change the determination condition of the determination item having a correlation with the specific determination item in accordance with a result of the evaluation described above. As described above, the determination condition of condition data Fc includes a determination condition imposing that all of the two or more determination items among the multiple determination items satisfy the determination condition (see "AND condition" in Fig. 5).

In the present embodiment, condition data storage section 712 stores multiple condition data Fc set in accordance with the configuration device information. The configuration device information is information included in control program M1 as described above and indicates at least one of the type and combination of the configuration devices necessary for executing the mounting process, and version of the firmware. When the configuration device is changed, the operation capability of component mounter 3 varies. Therefore, condition data storage section 712 stores multiple condition data Fc in accordance with the multiple types of configuration device information.

In the check process, determination section 72 determines the good or bad quality of control program M1 based on reference data Fs and condition data Fc. In a case where multiple condition data Fc are stored in condition data storage section 712, determination section 72 selects one from multiple condition data Fc in accordance with the configuration device information included in control program M1, and is used in the check process. In addition to reference data Fs and condition data Fc, determination section 72 determines the good or bad quality of control program M1 based on part data M2 corresponding to control program M1.

Specifically, for example, determination section 72 first analyzes control program M1 and acquires a set pattern of the configuration device, the information (type, size, volume, and weight of the board, or the like) of board 80, the movement range of mounting head 33, the maximum value of the movement speed, the maximum value of the movement speed of suction nozzle 34, or the like. Then, determination section 72 determines whether the determination reference and the determination condition are satisfied for each of the determination items.

Specifically, determination section 72 determines whether the conveyance speed in the conveyance process (S11) of board 80 is appropriate for the weight of board 80. Further, determination section 72 determines whether the load applied to board 80 or the component in the mounting cycle (S14) is appropriate in a relation to the number of backup members 111 and positions thereof. Further, determination section 72 determines whether the type of suction nozzle 34 used in the mounting process or an air pressure of the supplied negative pressure air is appropriate in relation to the component type. The details of the check process will be described later.

The check process for determining the good or bad quality of control program M1 can be executed at various timings. In the present embodiment, determination section 72 determines the good or bad quality of control program M1 in a case where a trigger event including a process set in advance is detected in addition to being based on the instruction of the operator to check device 70. With such a configuration, it is possible to execute the check process in conjunction with any timing and other processes (for example, execution determination of various mounting processes, and the like).

Here, part data M2 is used for the check process as described above. Part data M2 may be edited based on an error or the like that occurs during the execution of the mounting process. Then, part data M2 is stored in host computer 60 after being edited, and is shared, for example, in the same production line L. Therefore, it is preferable that the check process using part data M2 is executed in a state where the edition to part data M2 is reflected.

In consideration of the circumstances described above, determination section 72 is configured to be able to execute the check process at the timing when various trigger events are detected. Specifically, determination section 72 detects that condition data Fc is stored in condition data storage section 712 as the trigger event, and determines the good or bad quality of control program M1. With such a configuration, determination section 72 monitors condition data storage section 712 and executes the check process by stored condition data Fc.

In addition, determination section 72 detects an instruction input from an external device communicably connected to check device 70 as the trigger event, and determines the good or bad quality of control program M1. The external device described above may be one of the component mounters 3 constituting production line **L,** or may be a portable terminal (smart phone, tablet terminal, or the like) held by the operator. With such a configuration, it is possible to remotely instruct the execution of the check process.

Condition setting section 73 presents at least a part of the multiple determination items and receives an input by the user of the determination condition corresponding to the presented determination item. Specifically, for example, as illustrated in Fig. 5, condition setting section 73 presents, together, the determination reference of reference data Fs and the determination condition of condition data Fc to multiple determination items. At this time, condition setting section 73 may present multiple condition data Fc for each set pattern of the configuration devices.

Condition setting section 73 receives the input of the determination condition for the determination item via the input device of host computer 60 and updates condition data Fc. In the determination condition described above, in addition to the threshold and range for individual determination items, an AND condition having a correlation in multiple determination items is included. In a case where the input determination condition is in a level lower than the determination reference, condition setting section 73 may notify the user to that effect or may correct the determination condition to be equal to the determination reference. With such a configuration, it is possible to set the determination condition by considering the experience and performance of the user while the user confirms the existing determination reference.

### 7. Check Process of Control Program M1 by Check Device 70

The check process of control program M1 by check device 70 having the configuration described above will be described with reference to Fig. 6. Here, check device 70 executes the check process in a case where there is an instruction by the operator or in a case where the trigger event is detected. In addition, storage section 71 stores control program M1, part data M2, reference data Fs, and multiple pieces of condition data Fc.

In the check process, as illustrated in Fig. 6, determination section 72 first acquires the configuration device information included in control program M1 that is the target of the determination of the good or bad quality (S21). Next, determination section 72 selects one piece of data from the multiple pieces of condition data Fc in accordance with the acquired configuration device information (S22). Next, determination section 72 executes an analysis process of control program M1 (S23). Specifically, determination section 72 acquires the maximum value of the movement range and the movement speed of mounting head 33 in a case where it is assumed that the mounting process is executed, based on the instruction included in control program M1 and the various types of information included in part data M2.

Furthermore, the maximum value of the movement speed (including the rotation speed) by the XY movement, the lifting and lowering operation, and the rotation operation of individual components is obtained by the analysis process (S23). Further, the maximum load applied to the component at the time of the pick-up and mounting of the component is acquired by the analysis process (S23). Furthermore, the interval between the components mounted on board 80 is acquired by the analysis process (S23). As described above, various maximum values and ranges in accordance with the determination items are acquired by the analysis process (S23).

Determination section 72 determines (S24) the good or bad quality of control program M1 based on the result of the analysis process (S23). Specifically, determination section 72 determines whether the result of the analysis process (S23) satisfies the determination reference set in reference data Fs. At this time, determination section 72 may omit the determination of the good or bad quality by using reference data Fs for the determination item in which the determination condition is set in condition data Fc. In addition, determination section 72 determines whether the result of the analysis process (S23) satisfies the determination condition set in condition data Fc.

Check device 70 executes a notification process to the user based on the result of the determination (S24) of the good or bad quality of control program M1 (S25). Specifically, in a case where control program M1 satisfies the respective conditions in reference data Fs and condition data Fc, check device 70 notifies the user that control program M1 is "good" that is suitable for the mounting process.

On the other hand, in a case where control program M1 does not satisfy any one of the respective conditions in reference data Fs and condition data Fc, check device 70 notifies the user that control program M1 is "bad" that is not suitable for the mounting process. At this time, check device 70 may also notify which location of control program M1 and part data M2 does not satisfy the condition of which determination item. The notification described above may be sent out to a portable terminal or the like, for example, in a case where the check process is remotely instructed.

### 8. Effects by Configuration of Embodiment

Check device 70 of control program M1 includes reference data storage section 711 that stores reference data Fs, condition data storage section 712 that stores condition data Fc, and determination section 72 that determines the good or bad quality of control program M1 based on reference data Fs and condition data Fc in the check process.

With such a configuration, since condition data Fc can be made to correspond to specific component mounter 3 or a specific mounting process, it is possible to more reliably determine the good or bad quality of control program M1. As a result, it is possible to improve the quality of the board product to be produced.

### 9. Modified Aspect of Embodiment

### 9-1. Check Process

In the embodiment, check device 70 executes the check process based on the instruction from the operator or based on the detection of the trigger event. On the other hand, the check process may be executed based on either the instruction of the operator or the detection of the trigger event.

In the embodiment, condition data storage section 712 stores multiple condition data Fc in order to correspond to the set patterns of various configuration devices. In addition, condition data storage section 712 may store multiple condition data Fc different for each of various board products. Further, condition data storage section 712 may store multiple condition data Fc different for each of various required specifications for the same type of the board product. In such a configuration, determination section 72 selects one of the multiple condition data Fc based on information on the type of the board product and the required specification included in control program M1 or the like.

With such a configuration, it is possible to switch appropriate condition data Fc corresponding to the type of the board product and the required specification. Therefore, it is possible to more reliably determine the good or bad quality of control program M1. In addition, check device 70 may omit the switching of condition data Fc in accordance with the type or combination of the configuration devices, in contrast to the aspect of the embodiment and the aspect as described above. However, from the viewpoint of performing a more accurate determination of the good or bad quality of control program M1 reflecting the configuration device information, the type of the board product, and the required specification, the aspect exemplified in the embodiment is preferable.

In the embodiment, in check device 70, control program M1 which is the target of the determination of the good or bad quality is used in the mounting process by component mounter 3 as the board work machine. On the other hand, in check device 70, as long as the control program is used in the production process by the board work machine such as printer 2 or an adhesive application device in accordance with the respective functions, the control program may be the target of the determination of the good or bad quality.

Specifically, in check device 70, the control program used in the printing process of printer 2 as the board work machine is the target of the good or bad quality determination. In the printing process, printer 2 moves a squeegee in a required printing range of a maximum printable stroke. Thus, printer 2 prints the paste-like solder on the upper surface of board 80 in a pattern formed on the mask.

The control program used in the printing process described above includes the configuration device information such as the squeegee and the mask, information on board 80, the printing range, the lifting and lowering operation of the squeegee, the instruction of the movement operation, and the like. The determination items in reference data Fs and condition data Fc include the movement range and the movement speed of the squeegee, and the like. Check device 70 determines whether the printing range instructed by the control program is within the movable range of the squeegee based on reference data Fs. In addition, check device 70 determines whether the printing range is excess and deficiency based on condition data Fc.

As described above, according to the aspect of the embodiment and the modified aspect described above, condition data Fc can be made to correspond to a specific board work machine (component mounter 3, printer 2, or the like) or a specific production process (mounting process, printing process, or the like). Therefore, it is possible to more reliably determine the good or bad quality of the control program. As a result, it is possible to improve the quality of the board product to be produced.

9-2. Configuration of Check Device

In the embodiment, check device 70 is incorporated in host computer 60. On the other hand, check device 70 may adopt various aspects in addition to configuring one function of host computer 60. For example, check device 70 may be a dedicated external device communicably connected to production line L or host computer 60. At this time, check device 70 may be connected to the board work machine via the Internet. The same effects as those of the embodiment are achieved in any configuration.

### Reference Signs List

1: production system, 2: printer, 3: component mounter (board work machine), 4: reflow furnace, 5: inspector, 10: board conveyance device, 20: component supply device, 30: component transfer device, 33: mounting head, 34: suction nozzle (holding member), 41: part camera, 42: board camera, 50: control device, 60: host computer, 70: check device, 71: storage section, 711: reference data storage section, 712: condition data storage section, 72: determination section, 73: condition setting section, 80: board, M1: control program, M2: part data, Fs: reference data, Fc: condition data

## Claims

1. A control program check device (70) configured to perform a check process of a control program used for a production process by a board work machine, the check device comprising:
a reference data storage section (711) storing reference data (F_{S}) in which a determination reference for an execution propriety of the production process using the control program is set by a manufacturer of the board work machine for each of multiple determination items, wherein the multiple determination items include at least one of a movable range of a mounting head (33), an upper limit speed of the mounting head, an upper limit acceleration of the mounting head, an upper limit speed of a component held in the mounting head, an upper limit acceleration of the component held in the mounting head, a maximum load applied from the mounting head, minimum intervals of multiple components mounted on a board (80), a number of backup members (111) used in a mounting process, a maximum separation distance between a mounting position on the board and the backup member in the mounting process, a maximum load applied to the board at the mounting position, a conveyance speed of a board in a conveying-in process of the board, a type of suction nozzle that holds the component in the mounting process;
a condition data storage section (712) configured to store condition data (F_{C}) in which a determination condition that is set to a level higher than the determination reference for at least a part of the multiple determination items is set by a user of the board work machine for each of the determination items; and
a determination section (72) configured to determine good or bad quality of the control program based on the whether the determination reference and the determination condition are satisfied.

2. The control program check device according to Claim 1, further comprising:
a condition setting section (73) configured to present at least a part of the multiple determination items and receive an input, by the user, of the determination condition corresponding to the presented determination item.

3. The control program check device according to Claim 1 or 2,
wherein the determination condition of the condition data includes a condition set to a level higher than each of the determination items by imposing that all of two or more the determination items among the multiple determination items satisfy the determination condition.

4. The control program check device according to any one of Claims 1 to 3, wherein the determination section is configured to determine the good or bad quality of the control program in a case where a trigger event including a process set in advance is detected.

5. The control program check device according to Claim 4, wherein the determination section is configured to detect that the condition data is stored in the condition data storage section as the trigger event, and to determine the good or bad quality of the control program based on the condition data.

6. The control program check device according to Claim 4 or 5, wherein the determination section is configured to detect an instruction input from an external device communicably connected to the check device as a trigger event, and to determine the good or bad quality of the control program.

7. The control program check device according to any one of Claims 1 to 6, wherein the condition data storage section is configured to store the multiple condition data set in accordance with configuration device information including at least one of a type of a configuration device constituting the board work machine, a combination of multiple configuration devices, and a version of firmware incorporated in the configuration device, and wherein the determination section is configured to select one of the multiple condition data in accordance with the configuration device information included in the control program, and to determine the good or bad quality of the control program based on the selected condition data.

8. The control program check device according to any one of Claims 1 to 7, wherein the board work machine is a component mounter that is configured to mount a component at a mounting position on the board.

9. The control program check device according to Claim 8, wherein the control program includes the mounting position and a type of the component, wherein the component mounter is configured to control an operation of a holding member that holds the component based on the control program and part data in which at least one of an external shape, a withstand load, a maximum speed of movement, and a maximum acceleration of the movement of the component is set for each type of the multiple components, and wherein the determination section is configured to determine the good or bad quality of the control program based on the reference data, the condition data, and the part data corresponding to the control program.

## Patentansprüche

1. Eine Steuerprogramm-Prüfvorrichtung (70), die so konfiguriert ist, dass sie einen Prüfvorgang eines Steuerprogramms durchführt, das für ein Produktionsverfahren durch eine Plattenbearbeitungsmaschine verwendet wird, wobei die Prüfvorrichtung aufweist:
einen Referenzdatenspeicherabschnitt (711), der Referenzdaten (FS) speichert, in denen eine Bestimmungsreferenz für eine Ausführungsangemessenheit des Produktionsprozesses unter Verwendung des Steuerprogramms von einem Hersteller der Plattenbearbeitungsmaschine für jedes von mehreren Bestimmungselementen festgelegt ist, wobei die mehreren Bestimmungselemente mindestens eines der folgenden Elemente umfassen: einen beweglichen Bereich eines Montagekopfes (33), eine obere Begrenzungsgeschwindigkeit des Montagekopfes, eine obere Begrenzungsbeschleunigung des Montagekopfes, eine obere Begrenzungsgeschwindigkeit eines im Montagekopf gehaltenen Bauteils, eine obere Begrenzungsbeschleunigung des im Montagekopf gehaltenen Bauteils, eine vom Montagekopf ausgeübte maximale Belastung, minimale Abstände mehrerer auf einer Platte (80) montierter Bauteile, eine Anzahl von Stützelementen (111), die in einem Montageprozess verwendet werden, einen maximalen Abstand zwischen einer Montageposition auf der Platine und dem Stützelement im Montageprozess, eine maximale Belastung, die auf die Platine an der Montageposition ausgeübt wird, eine Fördergeschwindigkeit einer Platine in einem Einförderprozess der Platine, einen Typ einer Saugdüse, die das Bauteil im Montageprozess hält;
einen Zustandsdatenspeicherabschnitt (712), der so konfiguriert ist, dass er Zustandsdaten (FC) speichert, in denen eine Bestimmungsbedingung, die auf einen Wert höher als die Bestimmungsreferenz für mindestens einen Teil der mehreren Bestimmungspunkte eingestellt ist, von einem Benutzer der Plattenbearbeitungsmaschine für jeden der Bestimmungspunkte festgelegt wird; und
einen Bestimmungsabschnitt (72), der so konfiguriert ist, dass er die gute oder schlechte Qualität des Steuerprogramms auf der Grundlage der Erfüllung der Bestimmungsreferenz und der Bestimmungsbedingung bestimmt.

2. Die Steuerprogramm-Prüfvorrichtung gemäß Anspruch 1, die weiter aufweist:
einen Einstellungsabschnitt (73), der so konfiguriert ist, dass er mindestens einen Teil der mehreren Bestimmungselemente darstellt und eine Eingabe des Benutzers hinsichtlich der Bestimmungsbedingung empfängt, die dem dargestellten Bestimmungselement entspricht.

3. Die Steuerprogramm-Prüfvorrichtung gemäß Anspruch 1 oder 2,
wobei die Bestimmungsbedingung der Bedingungsdaten eine Bedingung aufweist, die auf einen höheren Wert als jeder der Bestimmungselemente festgelegt ist, indem vorgeschrieben wird, dass alle zwei oder mehr der Bestimmungselemente unter den mehreren Bestimmungselementen die Bestimmungsbedingung erfüllen.

4. Die Steuerprogramm-Prüfvorrichtung gemäß einem der Ansprüche 1 bis 3,
wobei der Bestimmungsabschnitt so konfiguriert ist, dass er die gute oder schlechte Qualität des Steuerprogramms in einem Fall bestimmt, in dem ein Triggerereignis, das einen vorab festgelegten Prozess aufweist, erkannt wird.

5. Die Steuerprogramm-Prüfvorrichtung gemäß Anspruch 4,
wobei der Bestimmungsabschnitt so konfiguriert ist, dass er erkennt, dass die Zustandsdaten als Auslöseereignis im Zustandsdatenspeicherabschnitt gespeichert sind, und die gute oder schlechte Qualität des Steuerprogramms auf der Grundlage der Zustandsdaten bestimmt.

6. Die Steuerprogramm-Prüfvorrichtung gemäß Anspruch 4 oder 5,
wobei der Bestimmungsabschnitt so konfiguriert ist, dass er eine von einer mit der Prüfvorrichtung kommunizierbar verbundenen externen Vorrichtung eingegebene Anweisung als Auslöseereignis erkennt und die gute oder schlechte Qualität des Steuerprogramms bestimmt.

7. Die Steuerprogramm-Prüfvorrichtung gemäß einem der Ansprüche 1 bis 6,
wobei der Zustandsdatenspeicherabschnitt so konfiguriert ist, dass er die mehreren Zustandsdatensätze gemäß den Konfigurationsgeräteinformationen speichert, die mindestens eines von einem Typ eines Konfigurationsgeräts, das die Platinenbearbeitungsmaschine bildet, einer Kombination aus mehreren Konfigurationsgeräten und einer Version der in dem Konfigurationsgerät enthaltenen Firmware umfassen, und
wobei der Bestimmungsabschnitt so konfiguriert ist, dass er einen der mehreren Zustandsdatensätze gemäß den im Steuerprogramm enthaltenen Konfigurationsgeräteinformationen auswählt und die gute oder schlechte Qualität des Steuerprogramms auf der Grundlage der ausgewählten Zustandsdaten bestimmt.

8. Die Steuerprogramm-Prüfvorrichtung gemäß einem der Ansprüche 1 bis 7,
wobei die Plattenbearbeitungsmaschine eine Bauteilmontagevorrichtung ist, die so konfiguriert ist, dass sie ein Bauteil an einer Bestückungsposition auf der Leiterplatte bestückt.

9. Die Steuerprogramm-Prüfvorrichtung nach Anspruch 8,
wobei das Steuerprogramm die Montageposition und einen Typ des Bauteils enthält,
wobei die Bauteilmontagevorrichtung so konfiguriert ist, dass sie einen Betrieb eines Halteelements, das das Bauteil hält, auf der Basis des Steuerprogramms und von Teiledaten steuert, in denen mindestens eines von einer Außenform, einer Belastbarkeit, einer maximalen Bewegungsgeschwindigkeit und einer maximalen Bewegungsbeschleunigung des Bauteils für jeden Typ der mehreren Bauteile festgelegt ist, und
wobei der Bestimmungsabschnitt so konfiguriert ist, dass er die gute oder schlechte Qualität des Steuerprogramms auf der Basis der Referenzdaten, der Zustandsdaten und der dem Steuerprogramm entsprechenden Teiledaten bestimmt.

## Revendications

1. Dispositif de vérification de programme de commande (70) configuré pour réaliser un processus de vérification d'un programme de commande utilisé pour un processus de production par une machine de travail de carte, le dispositif de vérification comprenant :
une section de stockage de données de référence (711) stockant des données de référence (Fₛ) dans lesquelles une référence de détermination pour une opportunité d'exécution du processus de production utilisant le programme de commande est établie par un fabricant de la machine de travail de carte pour chacun de multiples éléments de détermination, dans lequel les multiples éléments de détermination comportent au moins l'un parmi une plage de mobilité d'une tête de montage (33), une vitesse limite supérieure de la tête de montage, une accélération limite supérieure de la tête de montage, une vitesse limite supérieure d'un composant maintenu dans la tête de montage, une accélération limite supérieure du composant maintenu dans la tête de montage, une charge maximale appliquée par la tête de montage, des intervalles minimaux de multiples composants montés sur une carte (80), un nombre d'organes de soutien (111) utilisés dans un processus de montage, une distance maximale de séparation entre une position de montage sur la carte et l'organe de soutien dans le processus de montage, une charge maximale appliquée à la carte à la position de montage, une vitesse de transport d'une carte dans un processus de transport de la carte vers l'intérieur, un type de buse d'aspiration qui maintient le composant dans le processus de montage ;
une section de stockage de données de condition (712) configurée pour stocker des données de condition (F_{c}) dans lesquelles une condition de détermination qui est établie à un niveau supérieur à la référence de détermination pour au moins une partie des multiples éléments de détermination est établie par un utilisateur de la machine de travail de carte pour chacun des éléments de détermination ; et
une section de détermination (72) configurée pour déterminer une qualité bonne ou mauvaise du programme de commande sur la base que la référence de détermination et la condition de détermination sont satisfaites ou non.

2. Dispositif de vérification de programme de commande selon la revendication 1, comprenant en outre :
une section d'établissement de condition (73) configurée pour présenter au moins une partie des multiples éléments de détermination et recevoir une entrée, par l'utilisateur, de la condition de détermination correspondant à l'élément de détermination présenté.

3. Dispositif de vérification de programme de commande selon la revendication 1 ou 2,
dans lequel la condition de détermination des données de condition comporte une condition établie à un niveau supérieur à chacun des éléments de détermination en imposant que la totalité de deux des éléments de détermination ou plus parmi les multiples éléments de détermination satisfasse à la condition de détermination.

4. Dispositif de vérification de programme de commande selon l'une quelconque des revendications 1 à 3,
dans lequel la section de détermination est configurée pour déterminer la qualité bonne ou mauvaise du programme de commande dans un cas où un événement déclencheur comportant un processus établi à l'avance est détecté.

5. Dispositif de vérification de programme de commande selon la revendication 4, dans lequel la section de détermination est configurée pour détecter que les données de condition sont stockées dans la section de stockage de données de condition en tant qu'événement déclencheur, et pour déterminer la qualité bonne ou mauvaise du programme de commande sur la base des données de condition.

6. Dispositif de vérification de programme de commande selon la revendication 4 ou 5,
dans lequel la section de détermination est configurée pour détecter une instruction entrée par un dispositif externe connecté en communication au dispositif de vérification en tant qu'événement déclencheur, et pour déterminer la qualité bonne ou mauvaise du programme de commande.

7. Dispositif de vérification de programme de commande selon l'une quelconque des revendications 1 à 6,
dans lequel la section de stockage de données de condition est configurée pour stocker les multiples données de condition établies en fonction d'informations de dispositif de configuration comportant au moins l'un parmi un type d'un dispositif de configuration constituant la machine de travail de carte, une combinaison de multiples dispositifs de configuration, et une version de micrologiciel incorporé dans le dispositif de configuration, et
dans lequel la section de détermination est configurée pour sélectionner l'une des multiples données de condition en fonction des informations de dispositif de configuration comprises dans le programme de commande, et pour déterminer la qualité bonne ou mauvaise du programme de commande sur la base des données de condition sélectionnées.

8. Dispositif de vérification de programme de commande selon l'une quelconque des revendications 1 à 7,
dans lequel la machine de travail de carte est une machine de montage de composant qui est configurée pour monter un composant à une position de montage sur la carte.

9. Dispositif de vérification de programme de commande selon la revendication 8, dans lequel le programme de commande comporte la position de montage et un type du composant,
dans lequel la machine de montage de composant est configurée pour commander une opération d'un organe de maintien qui maintient le composant sur la base du programme de commande et de données de pièce dans lesquelles au moins l'une parmi une forme externe, une charge de résistance, une vitesse maximale de mouvement, et une accélération maximale du mouvement du composant est établie pour chaque type des multiples composants, et
dans lequel la section de détermination est configurée pour déterminer la qualité bonne ou mauvaise du programme de commande sur la base des données de référence, des données de condition, et des données de pièce correspondant au programme de commande.
